# EUROPÄISCHE PATENTSCHRIFT

(11) **EP 3 046 144 B1**
(45) Veröffentlichungstag und Bekanntmachung des Hinweises auf die Patenterteilung: **27.09.2017**
(21) Anmeldenummer: 15197404.5
(22) Anmeldetag: 02.12.2015
(51) Int. Cl.: H01L 23/473

(54) **KÜHLVORRICHTUNG FÜR EINEN KONVERTER EINER HOCHSPANNUNGS-GLEICHSTROM-ÜBERTRAGUNGSANLAGE**
COOLING DEVICE FOR A CONVERTER OF A HIGH VOLTAGE DIRECT CURRENT TRANSMISSION SYSTEM
DISPOSITIF DE REFROIDISSEMENT POUR UN CONVERTISSEUR D'UNE INSTALLATION DE TRANSFERT DE COURANT CONTINU-HAUTE TENSION

(30) Priorität: 12.01.2015 DE 102015200245
(43) Veröffentlichungstag der Anmeldung: 20.07.2016
(73) Patentinhaber: Siemens Aktiengesellschaft, 80333 München (DE)
(72) Erfinder: Benkert, Katrin, 90571 Schwaig (DE); Landes, Harald, 90607 Rückersdorf (DE); Leonide, André, 90762 Fürth (DE); Neubert, Rolf, 90763 Fürth (Bay.) (DE)

(56) Entgegenhaltungen:
- WO-A1-2007/149023

## Beschreibung

Die vorliegende Erfindung betrifft eine Kühlvorrichtung für einen Konverter einer Hochspannungs-Gleichstrom-Übertragungsanlage mit zumindest einem Kühlkörper, der einen Kühlkanal aufweist, mit einer Kühlleitung, welche fluidisch mit dem Kühlkanal verbunden ist, wobei der Kühlkanal und die Kühlleitung mit einer Kühlflüssigkeit durchströmt sind, und mit zumindest einer Steuerelektrode, die zumindest bereichsweise innerhalb der Kühlflüssigkeit angeordnet ist.

Bei der Hochspannungs-Gleichstrom-Übertragung (HGÜ) erfolgt die Energieübertragung über weite Entfernungen mit einer hohen Gleichspannung. Die Hochspannungs-Gleichstrom-Übertragungsanlagen weisen üblicherweise einen Konverter auf, der auch als Stromrichter bezeichnet werden kann. Dieser Konverter umfasst üblicherweise mehrere Leistungshalbleiterbauelemente wie beispielsweise Thyristoren, IGBTs, Transistoren oder andere Abwärme erzeugenden Bauelemente, mit denen die Gleichspannung in eine Wechselspannung und umgekehrt gerichtet werden kann. Die Leistungshalbleiterbauelemente werden üblicherweise auf hohen und unterschiedlichen Potenzialen gegen Erde betrieben.

Zum Abführen der Verlustwärme der Leistungshalbleiterbauelemente wird üblicherweise eine Kühlvorrichtung verwendet. Diese Kühlvorrichtung weist beispielsweise mehrere Kühlkörper auf, welche mit den Leistungshalbleiterbauelementen thermisch in Kontakt sind. Ferner weist die Kühlvorrichtung ein Kühlleitungssystem auf, das von einer Kühlflüssigkeit, insbesondere Wasser, durchströmt ist. Dabei können die Kühlkörper auch entsprechende Kühlkanäle aufweisen, welche Teil des Kühlleitungssystems sind. Das Kühlleitungssystem kann zudem einen Kühlwasserverteiler umfassen, der über Kühlkörperzuleitungen mit dem Kühlkanälen fluidisch verbunden ist.

Die Kühlkörper sind üblicherweise aus Aluminium gefertigt. Die Kühlkörper korrodieren in Kontakt mit dem Wasser aus zwei Gründen. Zum einen aufgrund der negativen freien Enthalpie der Aluminiumhydroxid-Bildung, die sich allein aus der Anwesenheit der Komponenten Aluminium, Wasser und gelöstem Aluminimumhydroxid ergibt. Diese Art der Korrosion findet bereits statt, wenn keinerlei zusätzliche elektrische Potenziale auf den Kühlkörper von außen aufgeprägt werden. Dieser Vorgang kann als rein chemisch getriebene Korrosion bezeichnet werden. Zum anderen gibt es in der HGÜ-Anlage noch die elektrisch getriebene Korrosion, die durch die Potenzialdifferenz zwischen den Kühlkörpern, die beispielsweise einige Kilovolt betragen kann, verursacht wird.

Um Überschläge zwischen den einzelnen Komponenten des Kühlleitungssystems und zwischen dem Kühlleitungssystem und den angrenzenden Komponenten zu verhindern, sind innerhalb jener Bereiche der Kühlleitung des Kühlleitungssystems , deren Wandungen nicht elektrisch leitend (also z. B. metallisch) ausgeführt sind, entsprechende Steuerelektroden angeordnet. Diese Steuerelektroden prägen der Kühlflüssigkeit in der Kühlleitung das gewünschte elektrische Potenzial der unmittelbaren Umgebung auf. Da es auch unabhängig von äußerlich aufgeprägten Potenzialgradienten stets zu einer Korrosion von den mit der Kühlflüssigkeit umströmten metallischen Bauteilen kommt, enthält die Kühlflüssigkeit stets gelöste Bestandteile, die wiederum zur Abscheidung von Belägen auf den Steuerelektroden führen. Diese Beläge neigen schließlich dazu, sich in Form von Partikeln abzulösen und Engstellen innerhalb des Kühlflüssigkeitskreislaufs bzw. innerhalb der Kühlleitung oder der Kühlkanäle zu verstopfen. Solche Engstellen können beispielsweise die Kühlkanäle in den Kühlkörpern sein. Dies kann dazu führen, dass die Leistungshalbleiterbauelemente nicht mehr ausreichend gekühlt werden können und somit beschädigt werden.

Hierzu beschreibt die WO 2007/149023 A1 einen Wandler in einer Stromrichterstation eines Hochspannungs-Übertragungssystems. Der Wandler weist eine Reihenschaltung von Stromrichterventilen mit Leistungshalbleitervorrichtungen auf. Des Weiteren sind Mittel zum Kühlen der Leistungshalbleitervorrichtungen mit Kühlblöcken, welche in Kontakt mit dem Leistungshalbleitervorrichtungen sind, und mit Leitungen zum Führen einer Kühlflüssigkeit vorgesehen. Die Leitungen können aus einem Kunststoff gebildet sein.

Es ist Aufgabe der vorliegenden Erfindung, eine Kühlvorrichtung für einen Konverter einer Hochspannungs-Gleichstrom-Übertragungsanlage bereitzustellen, welche kostengünstig bereitgestellt werden kann und zudem einen zuverlässigen Betrieb ermöglicht.

Diese Aufgabe wird durch eine Kühlvorrichtung mit den Merkmalen des Patentanspruchs 1 gelöst. Vorteilhafte Weiterbildungen der vorliegenden Erfindung sind Gegenstand der abhängigen Patentansprüche.

Eine erfindungsgemäße Kühlvorrichtung dient der Verwendung in einem Konverter einer Hochspannungs-Gleichstrom-Übertragungsanlage. Die Kühlvorrichtung umfasst zumindest einen Kühlkörper, der einen Kühlkanal aufweist. Darüber hinaus umfasst die Kühlvorrichtung einen Kühlwasserverteiler, welcher über eine Kühlkörperzuleitung fluidisch mit dem Kühlkanal verbunden ist. Dabei sind der Kühlkanal, der Kühlwasserverteiler und die Kühlkörperzuleitung von einer Kühlflüssigkeit durchströmt und sind Teil eines Kühlleitungssystems der Kühlvorrichtung. Darüber hinaus umfasst die Kühlvorrichtung zumindest eine Steuerelektrode, die zumindest bereichsweise innerhalb der Kühlflüssigkeit angeordnet ist. Ferner ist der Kühlkörper aus Aluminium gebildet. Dabei weist das Kühlleitungssystem zumindest ein Leitungselement auf, welches für Kohlenstoffdioxid durchlässig ist.

Die Kühlvorrichtung dient zum Kühlen eines Konverters einer Hochspannungs-Gleichstrom-Übertragungsanlage. Der Konverter, der auch als Stromrichter bezeichnet werden kann, umfasst üblicherweise eine Mehrzahl von Leistungshalbleiterbauelementen, wie beispielsweise Thyristoren. Diese Leistungshalbleiterbauelemente sind thermisch und elektrisch mit dem zumindest einen Kühlkörper der Kühlvorrichtung verbunden. Der Kühlkörper weist einen Kühlkanal auf, der mit der Kühlflüssigkeit durchströmt werden kann. Darüber hinaus ist ein Kühlwasserverteiler vorgesehen, der über eine Kühlkörperzuleitung mit dem Kühlkanal verbunden ist. Auch der Kühlwasserverteiler und die Kühlkörperzuleitung sind von der Kühlflüssigkeit durchströmt. Somit sind der Kühlkanal des Kühlkörpers, der Kühlwasserverteiler und die Kühlkörperzuleitung Teil eines Kühlleitungssystems, das weiterhin einen Wärmetauscher, eine Kühlmittelpumpe und eine Wasserreinigungsvorrichtung, bestehend aus Filter und Ionenaustauscher, enthalten kann. Das Kühlleitungssystem kann also mehrere Kühlleitungen umfassen. Auf diese Weise kann die von den Leistungshalbleiterbauelementen im Betrieb erzeugte Verlustwärme mit Hilfe der Kühlvorrichtung abgeführt werden.

Des Weiteren umfasst die Kühlvorrichtung eine oder mehrere Steuerelektroden. Dabei ist ein Teil der Steuerelektrode innerhalb der Kühlflüssigkeit angeordnet. Dabei ist ein erster Bereich der Steuerelektrode innerhalb der Kühlflüssigkeit angeordnet. Ein zweiter Bereich der Steuerelektrode kann außerhalb der Kühlflüssigkeit bzw. der Kühlleitung angeordnet sein. Die Steuerelektrode ist mit einem vorbestimmten elektrischen Potenzial verbunden, so dass sich der Potenzialverlauf innerhalb der Kühlleitung so einstellt, dass Potenzialdifferenzen zwischen der Kühlflüssigkeit und dem Kühlkörper minimiert werden und dass gleichzeitig auch die Gefahr von Überschlägen zwischen der Kühlleitung und den umgebenden Anlagenteilen beseitigt wird.

Das Kühlleitungssystem weist vorliegend zumindest ein Leitungselement auf, welches für Kohlenstoffdioxid (CO₂) bzw. Kohlendioxid durchlässig ist. Mit anderen Worten ist ein Teil bzw. ein Bereich der Kühlleitung für Kohlenstoffdioxid durchlässig bzw. permeabel. Auf diese Weise kann der Kühlflüssigkeit bzw. dem Kühlwasser Kohlenstoffdioxid aus der Luft zugeführt werden. In Versuchen hat sich gezeigt, dass eine Zuspeisung sehr geringer Mengen von Kohlenstoffdioxid zu der Kühlflüssigkeit die Bildung der Beläge auf den Steuerelektroden verhindern kann. Dadurch, dass der Kühlflüssigkeit bzw. dem Kühlwasser Kohlenstoffdioxid zugeführt wird, wird der pH-Wert der Kühlflüssigkeit verändert. Insbesondere wird die Kühlflüssigkeit saurer. Damit kann die Bildung von Aluminiumhydroxid innerhalb des Kühlwassers vermindert bzw. verhindert werden. Das Leitungselement ist insbesondere ein Teil des Kühlleitungssystems und dient zum Leiten der Kühlflüssigkeit.

Bevorzugt ist das Leitungselement von Luft umgeben und das Leitungselement ist derart ausgebildet, dass ein Teil des in der Luft enthaltenen Kohlenstoffdioxids durch das Leitungselement hindurch in die Kühlflüssigkeit eindiffundiert. In Versuchen hat sich gezeigt, dass bereits der Kohlenstoffdioxidgehalt der Luft, der etwa 0,04 % beträgt, ausreichend ist, um im Gleichgewicht mit dem Kühlwasser die aluminiumhaltigen Niederschläge auf den Steuerelektroden zu verhindern. Dabei kann das Leitungselement insbesondere von Luft umströmt sein. Somit kann auf einfache Weise die Umgebungsluft genutzt werden, um Kohlendioxid in die Kühlflüssigkeit einzubringen. Somit bedarf es keiner separaten Kohlenstoffdioxid-Behälter bzw. Gasflaschen, mit denen Kohlenstoffdioxid in die Kühlflüssigkeit eingebracht wird. Somit müssen keine Behälter oder Gasflaschen zu der Anlage transportiert werden. Dies erweist sich insbesondere als vorteilhaft, da die Konverter oft an abgelegenen und schwer zu erreichenden Stellen positioniert sind. Zudem müssen keine Sicherheitsvorkehrungen berücksichtigt werden, da keine Gasflaschen verwendet werden, welche eine Gefährdung verursachen können.

In einer Ausführungsform ist das Leitungselement zumindest teilweise aus Polypropylen gebildet. Grundsätzlich kann das Leitungselement aus einem Kohlenstoffdioxid durchlässigen Material, insbesondere einem Kohlenstoffdioxid durchlässigen Kunststoff, gebildet sein. Ein Leitungselement, welches aus Polypropylen gebildet ist, kann einfach und kostengünstig hergestellt werden.

In einer weiteren Ausführungsform ist das Leitungselement als Membran ausgebildet. Dabei kann es vorgesehen sein, dass Kohlenstoffdioxid durch das als Membran ausgebildete Leitungselement hindurch zu der Kühlflüssigkeit gelangen kann. Das Leitungselement kann in diesem Fall einen Bereich oder einen Abschnitt der Kühlleitung bilden.

In einer weiteren Ausgestaltung ist das Leitungselement als Schlauch und/oder als Rohr ausgebildet und bildet einen Teil des Kühlleitungssystems. Das Leitungselement kann in diesem Fall ein Schlauch oder ein Rohr sein, das aus einem für Kohlenstoffdioxid durchlässigen Material gebildet ist. Das Leitungselement bildet einen Teil oder einen Abschnitt des Kühlleitungssystems und dient zum Leiten der Kühlflüssigkeit. Somit kann auf einfache Weise erreicht werden, dass Kohlenstoffdioxid in die Kühlflüssigkeit gelangt und somit die Ablagerungen an den Steuerelektroden verhindert werden.

Weiterhin ist es vorteilhaft, wenn die Kühlvorrichtung derart ausgebildet ist, dass das Leitungselement von Luft umströmt ist. Hierzu kann beispielsweise ein Lüfter oder ein Wärmetauscher der Hochspannungs-Gleichstrom-Übertragungsanlage oder des Konverters genutzt werden, um einen Luftstrom bereitzustellen, welcher das Leitungselement umströmt. Dabei kann es auch vorgesehen sein, dass das Leitungselement derart innerhalb der Kühlvorrichtung positioniert ist, dass zwischen einem Bereich der Kühlvorrichtung, der eine erste Temperatur aufweist, und einem Bereich der Kühlvorrichtung, der eine zu der ersten Temperatur verschiedene zweite Temperatur aufweist, angeordnet ist. Zwischen den beiden Bereichen mit den unterschiedlichen Temperaturen wird in Folge der Konvektion ein Luftstrom erzeugt. Dieser Luftstrom kann dann das Leitungselement umströmen. Somit kann garantiert werden, dass an der Außenseite des Leitungselements ein Luftaustausch erfolgt und somit das in der Luft enthaltene Kohlenstoffdioxid von der Außenseite des Leitungselements durch das Leitungselement hindurch zu der Innenseite des Leitungselements und somit zu der Kühlflüssigkeit gelangt.

In einer weiteren Ausgestaltung ist das Leitungselement in einem Behälter angeordnet. Das Leitungselement kann auch in einem entsprechenden Gehäuse angeordnet sein. Hierbei kann das Leitungselement beispielsweise in dem Behälter mäanderförmig angeordnet sein. In dem Behälter kann, wie zuvor erwähnt, durch einen Lüfter oder in Folge der Konvektion ein Luftstrom bereitgestellt werden.

In einer weiteren Ausgestaltung weist die Kühlvorrichtung eine Mehrzahl von Kühlkörpern auf, wobei der Kühlwasserverteiler über eine Mehrzahl von Kühlkörperzuleitungen mit den jeweiligen Kühlkanälen der Kühlkörper fluidisch verbunden ist.. Die Kühlleitung kann einen Verteiler bzw. einen Kühlwasserverteiler aufweisen, der die Kühlflüssigkeit auf die Kühlkanäle der einzelnen Kühlkörper verteilt. Wenn in diesem Bereich der Kühlleitung das Leitungselement angeordnet ist, kann dafür gesorgt werden, dass die Kühlflüssigkeit, welche zu den Kühlkörpern bzw. deren Kühlkanal gelangt, einen vorbestimmten Kohlenstoffdioxidgehalt aufweist. Somit kann die Korrosion verhindert bzw. reduziert werden. Der Ionenaustauscher, der die Reinheit und damit die erforderliche geringe Leitfähigkeit der Kühlflüssigkeit aufrechterhält, fängt auch die durch das Lösen des Kohlenstoffdioxids in der Kühlflüssigkeit gebildeten Karbonat-Ionen ab und wirkt damit dem durch Eindiffusion durch die Leitungswandungen aufgenommenen Kohlenstoffdioxid entgegen. Durch dieses Zusammenspiel von Ionenaustauscher und Kühlleitungswänden stellt sich eine bestimmte Karbonatkonzentration im Kühlmittel ein, die geeignet ist, Aluminiumoxidniederschläge auf den Steuerelektroden zu verhindern.

Weiterhin kann die zumindest eine Steuerelektrode aus Platin gebildet sein. In einer alternativen Ausgestaltung ist die zumindest eine Steuerelektrode aus Edelstahl gebildet.

Weitere Merkmale der Erfindung ergeben sich aus den Ansprüchen, den Figuren und der Figurenbeschreibung. Die vorstehend in der Beschreibung genannten Merkmale und Merkmalskombinationen, sowie die nachfolgend in der Figurenbeschreibung genannten und/oder in den Figuren alleine gezeigten Merkmale und Merkmalskombinationen sind nicht nur in der jeweils angegebenen Kombination, sondern auch in anderen Kombinationen oder in Alleinstellung verwendbar, ohne den Rahmen der Erfindung zu verlassen.

Die Erfindung wird nun anhand von bevorzugten Ausführungsbeispielen sowie unter Bezugnahme auf die beigefügten Zeichnungen näher erläutert.

Dabei zeigen:
- FIG 1: eine schematische Darstellung einer Kühlvorrichtung für eine Hochspannungs-Gleichstrom-Übertragungsanlage;
- FIG 2: eine Kühlleitung der Kühlvorrichtung in einer schematischen Darstellung; und
- FIG 3: ein Leitungselement der Kühlleitung, welche in einem Behälter angeordnet ist.

In den Figuren werden gleiche und funktionsgleiche Elemente mit den gleichen Bezugszeichen versehen.

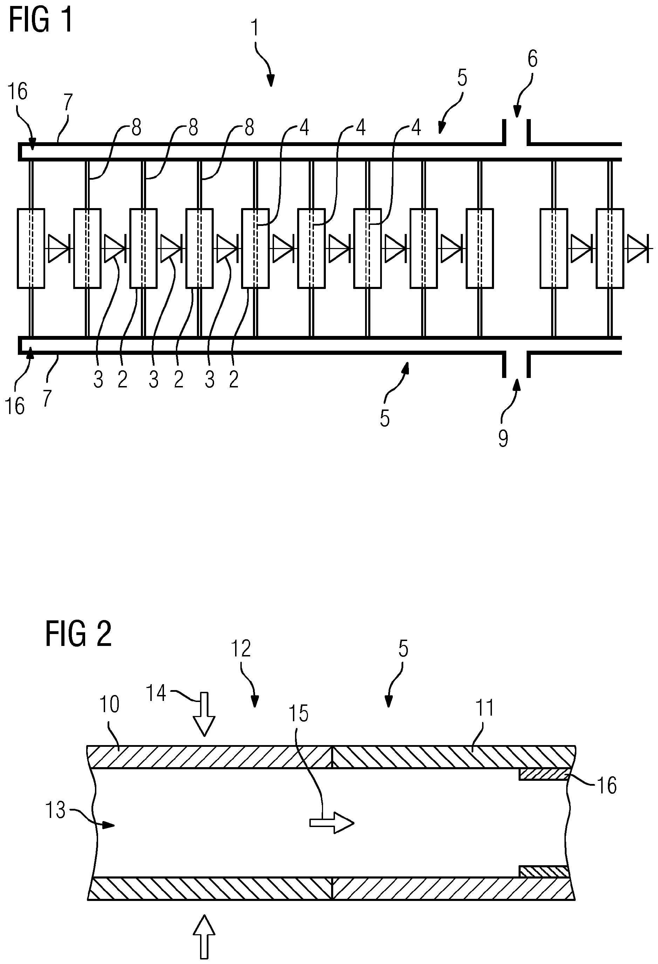

FIG 1 zeigt eine Kühlvorrichtung 1, die zum Kühlen eines Konverters einer Hochspannungs-Gleichstrom-Übertragungsanlage dient. Die Kühlvorrichtung 1 umfasst eine Mehrzahl von Kühlkörpern 2. Die Kühlkörper 2 dienen zum Kühlen von Leistungshalbleiterbauelementen 3 des Konverters. Hierzu sind die Leistungshalbleiterbauelemente 3 thermisch mit den Kühlkörpern 2 gekoppelt. Die Leistungshalbleiterbauelemente 3 können beispielsweise Thyristoren oder IGBTs sein. Die Leistungshalbleiterbauelemente 3 erzeugen im Betrieb des Konverters eine Abwärme. Die Kühlkörper 2 sind aus Aluminium gefertigt. Die Kühlkörper 2 weisen jeweils einen Kühlkanal 4 auf, der von einer Kühlflüssigkeit, insbesondere Kühlwasser, durchströmt werden kann.

Ferner umfasst die Kühlvorrichtung 1 einen Kühlwasserverteiler 7. Der Kühlwasserverteiler 7 dient dazu, die Kühlflüssigkeit entlang der Thyristorkette zu leiten. Der Kühlwasserverteiler 7 ist fluidisch über die Kühlkörperzuleitungen 8 mit den Kühlkanälen 4 der Kühlkörper 2 verbunden. Die Kühlwasserverteiler 7 weist vorliegend einen Zufluss 6 auf, durch welchen Kühlflüssigkeit eingebracht werden kann. Der Kühlwasserverteiler 7 ist ferner mit einer Mehrzahl von Kühlkörperzuleitungen 8 fluidisch verbunden. Die einzelnen Kühlkörperzuleitungen 8 sind wiederum fluidisch mit den Kühlkanälen 4 der Kühlkörper 2 verbunden. Die einzelnen Kühlkörper 2 sind über eine weitere Kühlkörperzuleitung 8 mit einem weiteren Kühlwasserverteiler 7 verbunden, der das Kühlwasser schließlich über einen Abfluss 9 in den weiteren Kühlkreislauf einspeist. Die Kühlwasserverteiler 7, die Kühlkörperzuleitungen 8 und die Kühlkanäle 4 sind Teil eines Kühlleitungssystems 5 der Kühlvorrichtung 1.

Anstelle der in FIG 1 gezeigten Kühlvorrichtung 1, bei der die Kühlkörper 2 wasserseitig parallel geschaltet sind, kann auch eine Kühlvorrichtung 1 verwendet werden, bei der die Kühlkörper 2 wasserseitig in Serie geschaltet sind. Es kann aber auch eine Kombination dieser beiden Versorgungskonzepte zur Anwendung kommen.

Im Betrieb der Kühlvorrichtung 1 korrodieren die Kühlkörper 2 im Kontakt mit dem Kühlwasser aus zwei Gründen. Zum einen aufgrund der negativen freien Enthalpie der Aluminiumhydroxid-Bildung, die sich allein aus der Anwesenheit der Komponenten Aluminium, Wasser und gelöstem Aluminiumhydroxid ergibt. Dieser Effekt kann auch als rein chemisch betriebene Korrosion bezeichnet werden. Zum anderen gibt es innerhalb der Kühlvorrichtung 1 zudem die elektrisch getriebene Korrosion, die durch eine Potenzialdifferenz zwischen den einzelnen Kühlkörpern 2, die beispielsweise einige Kilovolt betragen kann, getrieben wird. Diese kommt dadurch zustande, dass der zwar hohe aber endliche Widerstand des Kühlwassers innerhalb der (über weite Längenabschnitte aus elektrisch nicht leitendem Wandmaterial bestehenden) Kühlkörperzuleitungen 8 und der Verteilerleitungen 7 einen Strom von H⁺- und OH⁻-Ionen fließen lässt, der an den Kühlkörpern 2 entladen werden muss.

An einer Eintrittsstelle des Kühlmittelstroms, der in den Kühlkanal 4 des Kühlkörpers 2 fließt oder allgemein dort, wo die Kühlflüssigkeit erstmals auf Metall trifft, werden dann zwei in Konkurrenz stehende elektrochemische Prozesse ablaufen, deren Geschwindigkeit vom Material an dieser Stelle abhängt. Die erste Reaktion ist je nach Polarität die Entwicklung der Gase Wasserstoff bzw. Sauerstoff, die sich aufgrund der geringen Stromstärken und der Strömung der Kühlflüssigkeit in der Kühlflüssigkeit lösen und schadlos abtransportiert werden. Die andere Reaktion ist je nach Polarität die Bildung bzw. die Abscheidung von Metallionen oder von geladenen Komplexen, die Metalle und andere Elemente enthalten. Dadurch wird das Metall langfristig aufgelöst. Im Fall von Aluminium ist der Anteil des Metallzersetzungsstroms hoch, wodurch der Kühlkörper 2 durch den Stromfluss in der Kühlflüssigkeit abgetragen wird. Jegliche Art von Metallzersetzung führt zur Belastung der Kühlflüssigkeit mit Metall in löslicher und unlöslicher (z.B. kolloidaler) Form. Die löslichen Metallspezies fallen schließlich als Kolloide aus der Kühlflüssigkeit aus und setzen sich an den Wänden der Kühlwasserverteiler 7 und der Kühlkörperzuleitungen 8 und in den Kühlkörperkanälen 4 ab. Insbesondere schlagen sie sich auf den Steuerelektroden 16 nieder (in FIG 1 sind Steuerelektroden nicht eingezeichnet: sie würden z.B. an den Enden der Kühlwasserverteiler sitzen) und bilden einen harten, krustenartigen Belag. Nach einiger Zeit fallen Teile dieses Belages von den Steuerelektroden 16 ab, was im ungünstigsten Fall zu einer Verstopfung der Engstellen der Kühlkanäle 4 innerhalb der Kühlkörper 2 führt.

FIG 2 zeigt eine vergrößerte Darstellung der Kühlleitung des Kühlleitungssystems 5. Diese Kühlleitung kann ein Teil eines Kühlwasserverteilers 7 oder einer Kühlkörperzuleitung 8 sein. Dabei ist zu erkennen, dass die Kühlleitung ein Leitungselement 10 aufweist, welches aus einem für Kohlenstoffdioxid durchlässigen Material ausgebildet ist. Beispielsweise kann das Leitungselement 10 aus Polypropylen gebildet sein. Das Leitungselement 10 kann als Schlauch oder als Rohr ausgebildet sein. Zudem bildet das Leitungselement 10 einen Teil des Kühlleitungssystems, also des Kühlwasserverteilers 7 oder der Kühlkörperzuleitung 8. Der von dem Leitungselement 10 verschiedene Bereich 11 der Kühlleitung kann aus einem Material gebildet sein, welches nicht für Kohlenstoffdioxid durchlässig ist. In der Umgebung 12 der Kühlleitung befindet sich Luft. Insbesondere ist das Leitungselement 10 von Luft umströmt. Das in der Luft enthaltene Kohlenstoffdioxid kann von der Umgebung 12 des Leitungselements 10 in den Innenraum 13 des Leitungselements 10 bzw. des Kühlleitungssystems 5 gelangen. Dies ist vorliegend schematisch durch den Pfeil 14 verdeutlicht.

In dem Innenraum 13 des Kühlleitungssystems 5 strömt die Kühlflüssigkeit bzw. das Kühlwasser. Dies ist schematisch durch den Pfeil 15 verdeutlicht. Somit kann das Kohlenstoffdioxid in die Kühlflüssigkeit bzw. das Kühlwasser gelangen. Dies führt dazu, dass die Kühlflüssigkeit saurer wird. Dadurch kann die Bildung von Aluminiumablagerungen in dem Kühlwasser verhindert bzw. reduziert werden. Damit kann zudem verhindert werden, dass sich Ablagerungen innerhalb der Kühlwasserverteiler 7oder der Kühlkörperzuleitungen 8 oder innerhalb der Kühlkanäle 2 bilden.

Die Anordnung des Leitungselements 10 innerhalb des Kühlleitungssystems 5 ist grundsätzlich beliebig. Das Kühlleitungssystem 5 kann auch mehrere Leitungselemente 10 aufweisen. Das Leitungselement 10 kann einen Bereich des Kühlleitungssystems 5 bilden. Das Leitungselement 10 kann beispielsweise in den Kühlwasserverteilern 7 und/oder in den Verteilerleitungen 8 angeordnet sein.

Ferner ist in FIG 2 zu erkennen, dass die Kühlvorrichtung 1 Steuerelektroden 16 aufweist, die in dem Innenraum 13 der Kühlleitung, also des Kühlwasserverteilers 7 oder der Kühlkörperzuleitung 8 angeordnet sind. Die Steuerelektroden 16 können beispielsweise aus Platin oder aus Edelstahl gebildet sein. Die Steuerelektroden 16 sind vorliegend im Wesentlichen ringförmig ausgebildet und sind zumindest teilweise in dem Innenraum 13 des Kühlwasserverteilers 7 oder der Kühlkörperzuleitung8 angeordnet. Ein hier nicht dargestellter Bereich der Steuerelektrode 16 kann außerhalb der Kühlleitung angeordnet sein und mit einem vorbestimmten elektrischen Potenzial verbunden sein. Auf diese Weise können Potenzialunterschiede innerhalb des Kühlmittelkreislaufs ausgeglichen werden.

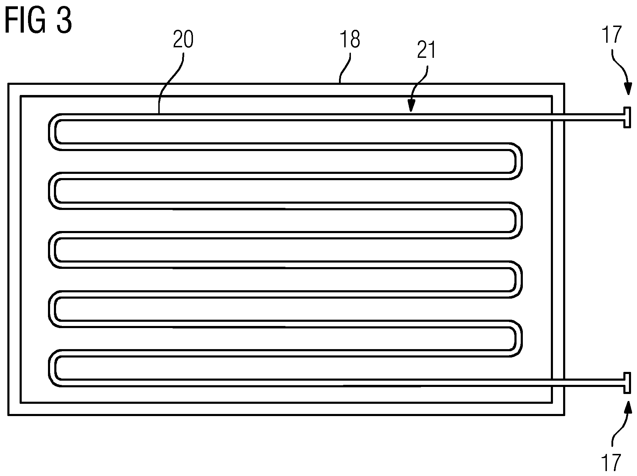

FIG 3 zeigt eine weitere Ausführungsform eines Leitungselements 20 innerhalb der Kühl- und Reinigungskomponenten der Anlage, die alle im wesentlichen auf dem gleichen Potential (Erdpotential) liegen. In diesem Ausführungsbeispiel ist das Leitungselement 20 als Schlauch ausgebildet. Das Leitungselement 20 weist entsprechende Anschlusselemente 17 auf, mit denen es mit Zuleitungen zu den Anschlüssen 6 bzw. 9 des Kühlleitungssystems 5, insbesondere eines Kaltwasserverteilers, verbunden ist und mit dem Bereich 11 des Kühlleitungssystems 5 verbunden werden kann. Vorliegend ist das Leitungselement 20 innerhalb eines Behälters 18 angeordnet. In einem Innenraum 19 des Behälters 18 kann ein Luftstrom bereitgestellt werden. Dieser Luftstrom kann beispielsweise durch einen hier nicht dargestellten Lüfter erzeugt werden. Es kann auch vorgesehen sein, dass das Leitungselement 20 zwischen zwei Bereichen der Kühlvorrichtung 1 bzw. des Konverters angeordnet ist, welche unterschiedliche Temperaturen aufweisen. Damit kann durch die Konvektion eine Luftströmung bereitgestellt werden. Somit kann erreicht werden, dass das Leitungselement 20 von Luft umströmt wird und das Kohlenstoffdioxid aus der Luft in den Innenraum 13 des Leitungselements 20 gelangt.

## Patentansprüche

1. Kühlvorrichtung (1) für einen Konverter einer Hochspannungs-Gleichstrom-Übertragungsanlage mit zumindest einem Kühlkörper (2), der einen Kühlkanal (4) aufweist, mit einem Kühlwasserverteiler (7), welcher über eine Kühlkörperzuleitung (8) fluidisch mit dem Kühlkanal (4) verbunden ist, wobei der Kühlkanal (4), der Kühlwasserverteiler (7) und die Kühlkörperzuleitung (8) mit einer Kühlflüssigkeit durchströmt sind und Teil eines Kühlleitungssystems (5) der Kühlvorrichtung (1) sind, und mit zumindest einer Steuerelektrode (16), die zumindest bereichsweise innerhalb der Kühlflüssigkeit angeordnet ist, **dadurch gekennzeichnet, dass** der zumindest eine Kühlkörper (2) aus Aluminium gebildet ist und das Kühlleitungssystem (5) zumindest ein Leitungselement (10, 20) aufweist, welches für Kohlenstoffdioxid durchlässig ist.

2. Kühlvorrichtung (1) nach Anspruch 1, **dadurch gekennzeichnet, dass** das Leitungselement (10, 20) von Luft umgeben ist und dass das Leitungselement (10, 20) derart ausgebildet ist, dass ein Teil des in der Luft enthaltenen Kohlenstoffdioxids durch das zumindest eine Leitungselement (10, 20) hindurch in die Kühlflüssigkeit eindiffundiert.

3. Kühlvorrichtung (1) nach Anspruch 1 oder 2, **dadurch gekennzeichnet, dass** das Leitungselement (10, 20) zumindest teilweise aus Polypropylen gebildet ist.

4. Kühlvorrichtung (1) nach einem der vorhergehenden Ansprüche, **dadurch gekennzeichnet, dass** das Leitungselement (10, 20) als Membran ausgebildet ist.

5. Kühlvorrichtung (1) nach einem der Ansprüche 1 bis 3, **dadurch gekennzeichnet, dass** das Leitungselement (10, 20) als Schlauch und/oder als Rohr ausgebildet ist und einen Teil des Kühlleitungssystems (5) bildet.

6. Kühlvorrichtung (1) nach einem der vorhergehenden Ansprüche, **dadurch gekennzeichnet, dass** die Kühlvorrichtung (1) derart ausgebildet ist, dass das Leitungselement (10, 20) von Luft umströmt ist.

7. Kühlvorrichtung (1) nach einem der vorhergehenden Ansprüche, **dadurch gekennzeichnet, dass** das Leitungselement (10, 20) in einem Behälter (18) angeordnet ist.

8. Kühlvorrichtung (1) nach einem der vorhergehenden Ansprüche, **dadurch gekennzeichnet, dass** die Kühlvorrichtung (1) eine Mehrzahl von Kühlkörpern (2) aufweist, wobei die Kühlwasserverteiler (7) über eine Mehrzahl von Kühlkörperzuleitungen (8) mit der Mehrzahl von Kühlkanälen (4) der Kühlkörper (2) fluidisch verbunden ist.

9. Kühlvorrichtung (1) nach einem der vorhergehenden Ansprüche, **dadurch gekennzeichnet, dass** die zumindest eine Steuerelektrode (16) aus Platin oder Edelstahl gebildet ist.

## Claims

1. Cooling device (1) for a converter of a high-voltage direct-current transmission system comprising at least one heat sink (2), which has a cooling channel (4), comprising a cooling water distributor (7), which is fluidically connected to the cooling channel (4) by way of a heat-sink supply line (8), the cooling channel (4), the cooling water distributor (7) and the heat-sink supply line (8) being flowed through by a cooling fluid and being part of a system of cooling lines (5) of the cooling device (1), and comprising at least one control electrode (16), which at least in certain regions is arranged within the cooling fluid, **characterized in that** the at least one heat sink (2) is formed from aluminium and the system of cooling lines (5) has at least one line element (10, 20) that is permeable to carbon dioxide.

2. Cooling device (1) according to Claim 1, **characterized in that** the line element (10, 20) is surrounded by air and **in that** the line element (10, 20) is formed in such a way that part of the carbon dioxide contained in the air diffuses into the cooling fluid through the at least one line element (10, 20).

3. Cooling device (1) according to Claim 1 or 2, **characterized in that** the line element (10, 20) is at least partially formed from polypropylene.

4. Cooling device (1) according to one of the preceding claims, **characterized in that** the line element (10, 20) is formed as a membrane.

5. Cooling device (1) according to one of Claims 1 to 3, **characterized in that** the line element (10, 20) is formed as a hose and/or as a tube and forms part of the system of cooling lines (5).

6. Cooling device (1) according to one of the preceding claims, **characterized in that** the cooling device (1) is formed in such a way that the line element (10, 20) is flowed around by air.

7. Cooling device (1) according to one of the preceding claims, **characterized in that** the line element (10, 20) is arranged in a container (18).

8. Cooling device (1) according to one of the preceding claims, **characterized in that** the cooling device (1) has a plurality of heat sinks (2), the cooling water distributor (7) being fluidically connected to the plurality of cooling channels (4) of the heat sinks (2) by way of a plurality of heat-sink supply lines (8).

9. Cooling device (1) according to one of the preceding claims, **characterized in that** the at least one control electrode (16) is formed from platinum or high-grade steel.

## Revendications

1. Dispositif (1) de refroidissement d'un convertisseur d'une installation de transfert de courant continu en haute tension, comprenant au moins un refroidisseur (2) ayant un conduit (4) de refroidissement, un répartiteur (7) d'eau de refroidissement relié par un conduit (8) d'entrée du refroidisseur fluidiquement au conduit (4) de refroidissement, dans lequel le conduit (4) de refroidissement, le répartiteur (7) d'eau de refroidissement et le conduit (8) d'entrée du refroidisseur sont parcourus par un liquide de refroidissement et font parties d'un système (5) de conduite (8) de refroidissement du dispositif (1) de refroidissement, et au moins une électrode (16) de commande, disposée au moins par endroit au sein du liquide de refroidissement, **caractérisé en ce que** le au moins un refroidisseur (2) est en aluminium et le système (5) de conduite de refroidissement a au moins un élément (10, 20) de conduite, qui est perméable au dioxyde de carbone.

2. Dispositif (1) de refroidissement suivant la revendication 1, **caractérisé en ce que** l'élément (10, 20) de conduite est entouré d'air et **en ce que** l'élément (10, 20) de conduite est constitué de manière à ce qu'une partie du dioxyde de carbone contenu dans l'air diffuse dans le liquide de refroidissement en traversant le au moins un élément (10, 20) de conduite.

3. Dispositif (1) de refroidissement suivant la revendication 1 ou 2, **caractérisé en ce que** l'élément (10, 20) de conduite est au moins en partie en polypropylène.

4. Dispositif (1) de refroidissement suivant l'une des revendications précédentes, **caractérisé en ce que** l'élément (10, 20) de conduite est constitué sous la forme d'une membrane.

5. Dispositif (1) de refroidissement suivant l'une des revendications 1 à 3, **caractérisé en ce que** l'élément (10, 20) de conduite est constitué sous la forme d'un tuyau souple et/ou d'un tuyau et forme une partie du système (5) de conduite de refroidissement.

6. Dispositif (1) de refroidissement suivant l'une des revendications précédentes, **caractérisé en ce que** le dispositif (1) de refroidissement est constitué de manière à ce que l'élément (10, 20) de conduite soit léché par de l'air.

7. Dispositif (1) de refroidissement suivant l'une des revendications précédentes, **caractérisé en ce que** l'élément (10, 20) de conduite est disposé dans un récipient (18).

8. Dispositif (1) de refroidissement suivant l'une des revendications précédentes, **caractérisé en ce que** le dispositif (1) de refroidissement a une pluralité de refroidisseurs (2), le répartiteur (7) d'eau de refroidissement communiquant fluidiquement par une pluralité de conduits (8) d'entrée de corps de refroidisseur avec la pluralité de conduits (4) de refroidissement du refroidisseur (2).

9. Dispositif (1) de refroidissement suivant l'une des revendications précédentes, **caractérisé en ce que** la au moins une électrode (16) de commande est en platine ou en acier fin.
